(19) Europäisches Patentamt

European Patent Office

Office européen des brevets

(11) **EP 1 196 790 B1**

(12) **EUROPEAN PATENT SPECIFICATION**

(45) Date of publication and mention
of the grant of the patent:
**19.05.2004 Bulletin 2004/21**

(21) Application number: **00947340.6**

(22) Date of filing: **14.07.2000**

(51) Int Cl.⁷: **G01R 31/316**

(86) International application number:
**PCT/US2000/019161**

(87) International publication number:
**WO 2001/006273 (25.01.2001 Gazette 2001/04)**

(54) **APPARATUS AND METHOD FOR TEMPERATURE CONTROL OF IC DEVICE DURING TEST**

GERÄT UND VERFAHREN ZUR TEMPERATURKONTROLLE VON INTEGRIERTEN SCHALTUNGEN WÄHREND DER PRÜFUNG

APPAREIL ET PROCEDE DE REGLAGE DE LA TEMPERATURE D'UN DISPOSITIF A CIRCUIT INTEGRE A L'ESSAI

(84) Designated Contracting States:
**AT BE CH CY DE DK ES FI FR GB GR IE IT LI LU MC NL PT SE**

(30) Priority: **15.07.1999 US 143932 P**

(43) Date of publication of application:
**17.04.2002 Bulletin 2002/16**

(73) Proprietor: **Delta Design, Inc.**
**Poway, CA 92064 (US)**

(72) Inventors:
• **DIBATTISTA, Larry**
**Powell, OH 43065 (US)**
• **MALINOSKI, Mark**
**Dublin, OH 43017 (US)**
• **SHITARA, Tomoya**
**Campbell, CA 95008 (US)**

(74) Representative: **Haines, Miles John et al**
**D. Young & Co.**
**21 New Fetter Lane**
**London EC4A 1DA (GB)**

(56) References cited:
EP-A- 0 631 149    DE-A- 19 700 839
US-A- 4 870 355    US-A- 5 084 671
US-A- 5 210 485    US-A- 5 911 897

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

**CROSS-REFERENCE TO RELATED APPLICAT10N**

This application claims the priority of previously filed provisional application number 60/143,932, filed on July 15, 1999.

**FIELD OF THE INVENTION**

The present invention relates to the temperature control of integrated circuit ("IC") devices during testing. In particular, the invention relates to apparatus and methods for controlling the temperature of such devices when tested at wafer level.

**BACKGROUND OF THE INVENTION**

Functional testing of IC devices is necessary to verify performance prior to shipping to an end user. It is desirable to test such devices as early as possible in the manufacturing process so that any non-functioning devices can be removed from the process before further expensive processing steps are applied. The earliest stage in manufacturing at which full functionality of the devices can be tested is at the end of the processing of the wafer on which the devices are formed. Testing at this stage, often known as "wafer probing," has been used in previous testing strategies. Wafer prober interfaces are used as an interface with a test system. In a wafer prober interface, temporary contacts such as needles are placed into electrical contact with pads formed on the device, such as for power and input/output signals. The pads are formed while the device is still part of the wafer, that is, before the wafer is cut into individual or "singulated" devices. A test pattern is then applied via these pads.

Thermal control of devices during testing has been recognized as an issue in testing of IC devices. One particular problem with testing IC devices is that they are tested before temperature control devices such as heat sinks and fans are attached. For devices in which the power dissipation of the chip is relatively constant or only varies in a small range, temperature control can be achieved by placing the device in contact with a large thermal mass, which is held at the desired temperature. This method is generally unsatisfactory, however, if the value of the power dissipation of the device varies over a wide range.

One approach to controlling the temperature of a device under test comprises placing the device in contact with a temperature forcing system. The temperature forcing system is used to vary the degree of cooling or heating in order to maintain the device at the desired temperature set point during the test. Control of such systems typically uses a feedback loop based on the output of a temperature sensor, which is in contact with the device or, in certain cases, built into the device itself.

Typical temperature forcing systems often use forced air convection systems that extend well beyond the desired forcing temperature range at both the hot and cold ends. In this way, an attempt can be made to accelerate the device's temperature conditioning by overcooling or overheating. As the nominal power density of the devices continues to increase, the ability of forced air convection systems to overcool reaches practical limits, causing increases in the temperature error between the desired and actual temperatures. Another problem is the increased sensitivity that devices fabricated in the latest processes have to high temperatures. The potential for chip damage due to overheating adds risk to the use of the overheating approach. The combination of the limited ability to overcool and the need to be more conservative by not overheating results in an increased time to reach set point, with lost utilization of expensive test equipment and engineering personnel as the expense.

Another approach to the design of temperature forcing systems involves the use of dual liquid conduction systems, with one hot liquid and one cold liquid. The proportion of the liquids is mechanically metered to effect the desired forcing temperature. To achieve fast response times, this approach requires that the metering occur very close to the device. This imposes mechanical packaging constraints, which limit flexibility in bringing the surface of the temperature forcing system control surface into contact with the device or the device package. Even without these constraints, the mechanical metering of the dual liquids is slow in changing the forcing temperature when compared to the temperature changes induced by the device's instantaneous power dissipation. This relatively slow change also causes increased error between the desired and actual temperatures.

Examples of the systems described above can be found in the following U.S. Patents: 5,420,521; 5,297,621; 5,315,240; 5,205,132; 5,309,090; 5,821,505; 5,172,049; and 4,734,872. Some systems only heat the chip and do not provide a means for removing heat from the chip. Other systems increase or lower the chip temperature with a gas jet or with an immersing liquid. In these latter systems, the temperature accuracy for the chip is limited by the speed at which the temperature of the gas jet or liquid can be increased or decreased.

To date, the approach used in wafer probing for temperature control is to provide a thermal mass in the form of a heated and/or cooled chuck on which the wafer is placed during testing. The chuck attempts to maintain the temperature of the whole wafer at a desired set point during testing. An example of such a system is the ThermoChuck available from Temptronic Corp. of Newton, Massachusetts. However, it is not possible for such a system to respond to localized temperature changes arising from an individual high performance device on a wafer being tested at speed. This limitation has effectively prevented wafer probing from being used to test high performance devices at speed early in the manufacturing process.

US-A-5,210,485 describes a bum-in wafer test apparatus that heats a plurality of integrated circuit devices on a wafer during testing. A heater element is adapted to evenly and controllably heat the individual devices, and comprises a plurality of electrically conductive serpentine traces on a silicon substrate. The number and arrangement of traces corresponds to the number and arrangement of devices on the wafer.

An alternative bum-in test apparatus is described in EP-A-0,631,149. A plurality of semi-conductor chips are heated during testing by placing the individual chips, singularised from a wafer, in a heating assembly having an aperture for each chip. Each aperture has its own heating element, the elements being powered by a common power line.

DE-A-197 00 839 describes an alternative wafer test apparatus, in which a temperature stabilisation device is provided for setting the temperature of a semiconductor wafer to be tested. The temperature stabilisation device comprises a first heat stabilisation stage for setting the temperature of the wafer and a second heat stabilisation stage for removing heat dissipated from the first stage. The two stages are independently controllable, and preferably have the form of Peltier devices.

A need has arisen for a temperature control system which overcomes or at least reduces some of the problems encountered in controlling the temperature of devices when using wafer probing for testing.

## SUMMARY OF THE INVENTION

Briefly, according to one aspect of the invention, there is provided an apparatus for control of integrated circuit devices under test. The apparatus includes a heat exchanger having a surface disposed to contact each of the plurality of integrated circuit devices. The surface has a plurality of regions corresponding to respective ones of the plurality of integrated circuit devices. During testing, the temperature of each of the plurality of integrated circuit devices is individually controlled at each of the plurality of regions.

Consistent with this aspect of the invention, the heat exchanger may comprise a chuck having a plurality of heating elements disposed at each of the regions, and the chuck may include a heat sink wherein each of the heating elements regulates the temperature of a corresponding one of the regions at a temperature above a temperature determined by the heat sink.

Also consistent with this aspect of the invention, the temperature of each region may be individually controlled by a heating element disposed on a heat sink or by a plurality of heating elements disposed over a corresponding one of a plurality of heat sinks.

Also consistent with this aspect of the invention, the plurality of integrated circuit devices may be formed on a wafer and the surface may be disposed to contact the wafer such that the plurality of regions correspond to respective ones of the plurality of integrated circuit devices formed on the wafer. Alternatively, the plurality of integrated circuit devices may be singulated devices, and the surface is disposed to contact the singulated devices such that the plurality of regions correspond to respective ones of the singulated devices.

In one embodiment, the heat exchanger comprises a chuck for locating the devices during testing. The apparatus further comprises multiple temperature control devices to individually control the temperature of each of the plurality of integrated circuit devices arranged in the chuck to correspond with the arrangement on the wafer of the devices being tested.

Consistent with this embodiment of the invention, the chuck may be provided with means for controlling its temperature during the testing, and the means for controlling the chuck temperature may comprise a supply of temperature-controlled fluid or an electrical device.

Also consistent with this embodiment of the invention, the multiple temperature control devices may comprise heating elements, and a heat exchanger body may be provided for each heating element or a single heat exchanger body may be provided for the multiple heating elements.

Briefly, according to another aspect of the invention, there is provided a method of controlling the temperature of a plurality of integrated circuit devices during testing. The method includes placing the plurality of integrated circuit device in contact with a respective one of a plurality of regions of a surface of a heat exchanger. The temperature of each of the plurality of integrated circuit devices at each of the plurality of regions is controlled individually.

Consistent with this aspect of the invention, the heat exchanger may comprise a chuck having a plurality of heating elements disposed at each of the regions, and the chuck may include a heat sink wherein each of the heating elements regulates the temperature of a corresponding one of the regions at a temperature above a temperature determined by the heat sink.

Also consistent with this aspect of the invention, the temperature of each region may be individually controlled by a heating element disposed on a heat sink or by a plurality of heating elements disposed over a corresponding one of a plurality of heat sinks.

Also consistent with this aspect of the invention, the plurality of integrated circuit devices may be formed on a wafer and the surface may be disposed to contact the wafer such that the plurality of regions correspond to respective ones of the plurality of integrated circuit devices formed on the wafer. Alternatively, the plurality of integrated circuit devices may be singulated devices, and the surface may be disposed to contact the singulated devices such that the plurality of regions correspond to respective ones of the singulated devices.

Consistent with this aspect of the invention, the placing the plurality of integrated circuit devices comprises locating the devices at a test location at which temperature control devices are arranged to correspond with the arrangement of the devices being tested. The individual devices are tested.

Consistent with this aspect of the invention, the method may further comprise singulating the devices formed on the wafer before testing, wherein the singulated devices are arranged on the chuck in the same arrangement as when they were formed on the wafer.

Consistent with aspects of the invention, the temperature of each of a plurality of integrated circuit devices may be individually controlled based on the power usage of the integrated circuit devices.

## BRIEF DESCRIPTION OF THE DRAWINGS

Fig. 1 shows a schematic side view of a heat exchanger;

Fig. 2A is a high level block diagram showing the relationship between a heat exchanger, a device under test, and a thermal control system consistent with the present invention;

Figs. 2B-2C show configurations of the heat exchanger of Fig. 2A;

Fig. 3 shows a schematic system level perspective view of a testing apparatus consistent the present invention;

Fig. 4 shows a block diagram of the coolant system of Fig. 3;

Fig. 5 depicts an example of a chuck consistent with the present invention;

Fig. 6 shows a high level block diagram of the control electronics for the system controller of Fig. 3;

Fig. 7 shows a partial block diagram of the thermal control board of Fig. 6;

Figs. 8A-8B depict embodiments of a heat exchanger with multiple heaters, thermally connected to individual devices consistent with the present invention;

Fig. 9 shows a schematic diagram of the thermal control circuit of Fig. 3;

Figs. 10A and 10B show perspective and top views, respectively, of a heat exchanger for use with wafers consistent with the present invention; and

Figs. 11A and 11 B show perspective and top views, respectively, of a heat exchanger with a carrier arrangement for singulated devices consistent with the present invention.

## DETAILED DESCRIPTION OF THE PREFERRED EMBODIMENTS

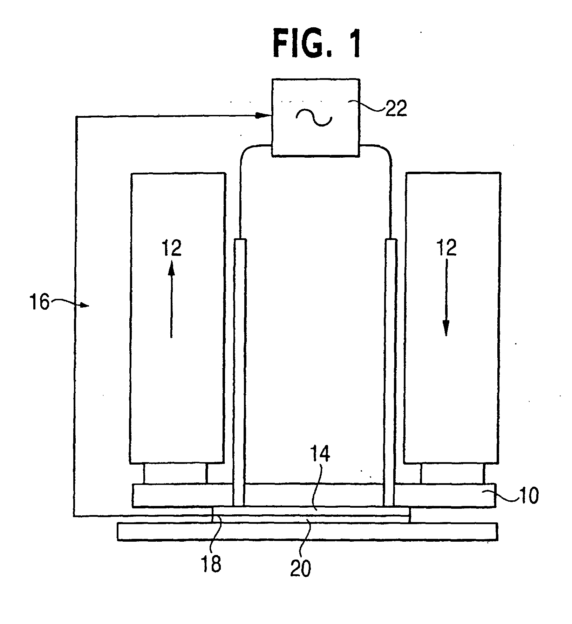

Fig. 1 illustrates a heat exchanger that provides conductive thermal control of a device 20. The heat exchange includes a heat sink 10, which accommodates a circulating cooling liquid 12, a heating element 14, and a closed loop control 16 to hold a contact surface 18, of the test device and a device 20, at a set point temperature. The heat exchanger device also includes a power source 22 used by the closed loop control 16 in maintaining the contact surface 18 at the set point temperature.

In this example, the liquid 12 is preferably held at a constant temperature that is sufficiently below the set point temperature, which can be above or below the ambient temperature. The heating element 14 is then used to bring the temperature of the contact surface 18 to the desired set point temperature. In such a configuration, the liquid 12 cools the heating element 14 regardless of whether the set point temperature is above or below the ambient temperature.

The heat exchanger of Fig. 1 allows the contact surface temperature to be changed rapidly to compensate for variations in an IC device's instantaneous power dissipation. Also, the heating element 14 can be fairly compact, allowing more flexibility to accommodate typical device testing situations.

The temperature range for the liquid is typically -60°C to +60°C. At any point in this temperature range, the viscosity of the liquid and the resulting flow rate are preferably consistent within some percentage to avoid negatively impacting the thermal control performance. One approach to achieve this combination of percentages which may be advantageously used with the apparatus according to the invention is described in commonly assigned U.S. Patent Application Serial No. 09/352,762, entitled "APPARATUS, METHOD AND SYSTEM OF LIQUID-BASED, WIDE RANGE, FAST RESPONSE TEMPERATURE CONTROL OF ELECTRONIC DEVICES", filed on July 14, 1999.

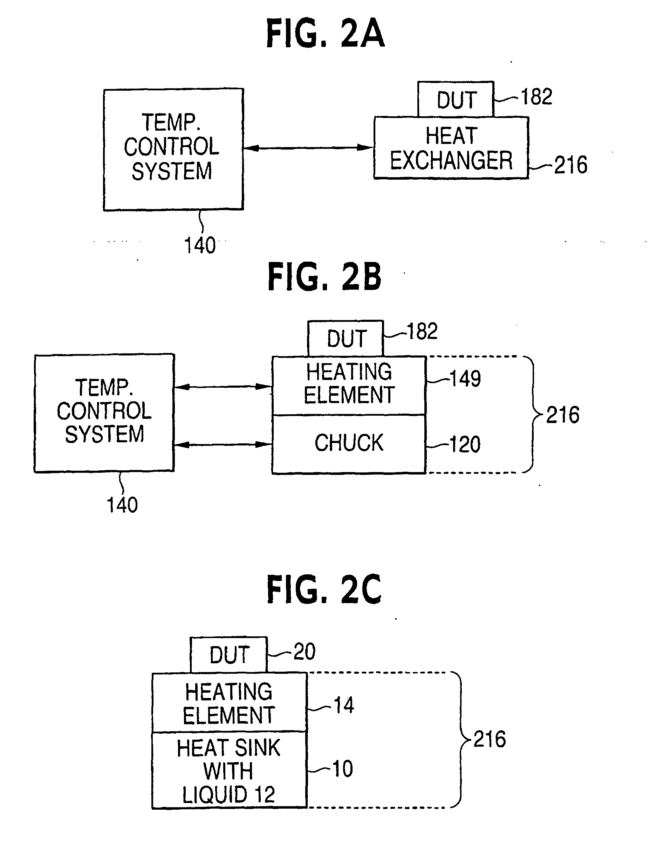

Fig. 2A is a simplified block diagram of a system such as that shown in Fig. 1. In Fig. 2A, a temperature control system 140 controls a heat exchanger 216 which is in thermal contact with a device under test ("DUT") 182. The DUT 182 is preferably in physical contact with a surface of the heat exchanger 216. In this diagram, a single DUT is shown. As explained below, however, the present invention allows for temperature control of the DUT 182 to a plurality of integrated circuit devices that may be tested at the same time.

Figs. 2B and 2C show examples of more specific implementations of the heat exchanger 216 and DUT 182 generally shown in Fig. 2A. In Fig. 2B, the heat exchanger 216 comprises a chuck 120 having a heating element 149 in thermal contact with the DUT 182. In Fig. 2C, the heat exchanger 216 comprises the heating element 14 and a heat sink 10 whose temperature is regulated with a liquid 12, such as in the manner described in reference to in Fig. 1.

Now that the more generalized aspect of a heat exchanger for thermal control of a DUT has been described, preferred embodiments of the invention are now discussed In which multiple DUTs undergoing wafer level testing are thermally controlled on an Individual basis.

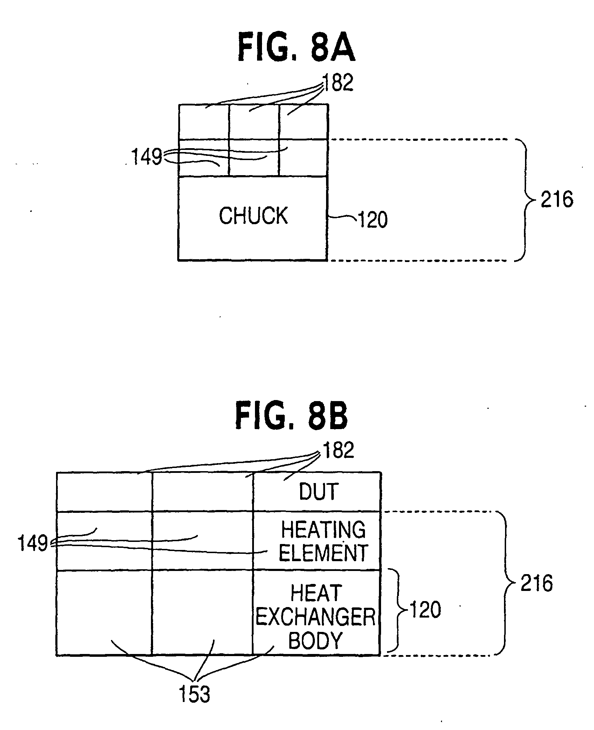

As shown in Fig. 8A, a heat exchanger 216 according to the invention comprises a chuck 120 on which a plurality of heating elements 149 are incorporated. A plurality of DUTs 182 are located on the heating element 149, preferably in a one-to-one correspondence. This one-to-one correspondence between the heating elements 149 and the DUTs 182 provides the ability to control independently the temperature of each DUT 182 during a test.

Fig. 8B shows an alternate embodiment in which separate heat exchanger bodies 153 are provided for each of a plurality of heaters 149. Each heat exchanger bodies 153 contain a cavity which allows a liquid to flow through them to act as a heat sink in the manner discussed above. The heat exchanger bodies 153 may be part of a single chuck 120. Although Fig. 8B shows separate heat exchanger bodies 153 for each heating element 149, these bodies 153 may thermally impact each other depending on the level of thermal insulation between them. The same is true for the heating elements 149 themselves, irrespective of how many heat exchanger bodies 153 are present.

The individual heating elements 149, or heaters, may be implemented, for example, as a three layer co-fired aluminum nitride heater substrate with a heater trace between the first two layers and the RTD trace between the last two layers. The heater trace provides the heat energy and the RTD trace provides temperature information. The two traces are electrically isolated while being at essentially the same thermal position due to the thermal conductivity of the aluminum nitride layers. In a preferred embodiment, the heating elements 149 are resistive heaters. It is to be understood, however, that many other types of heating elements 149 may be used, including without limitation a heater utilizing lasers, other optics, or electro-magnetic waves.

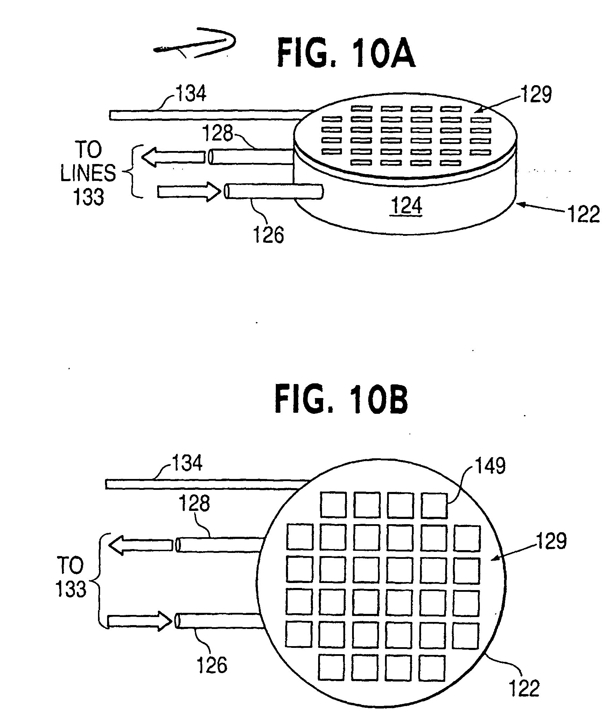

Figs. 10A and 10B are respective perspective and top views of an exemplary heat exchanger in accordance with the invention. A chuck 122 serves to locate, that is, align, a whole wafer. Preferably, the chuck 122 is a fluid cooled, incorporating fluid cavity 124, a fluid inlet 126 and fluid outlet 128. The inlet 126 and the outlet 128 are connected through fluid supply lines 133 to the temperature control system such as that described above in reference to Fig. 1. Disposed on the upper surface of the fluid cooled chuck 122 is an array 129 of heating elements 149, which are connected to the temperature control system via a heater control cable 134. Each heating element 149 in the array 129 has a size and shape corresponding to that of the associated IC device to be tested on the wafer and the pattern of heating elements 149 matches that of the devices on the wafer. Consequently, when a wafer is positioned on the chuck 120, each device will be sitting on top of a heating element 149.

In this embodiment, each heating element 149 is controlled independently of the others. As a result, temperature control may be applied to the particular device under test that is located on corresponding heating element 149 when a wafer is placed on the chuck 120 in such away that each DUT is maintained at its set point temperature.

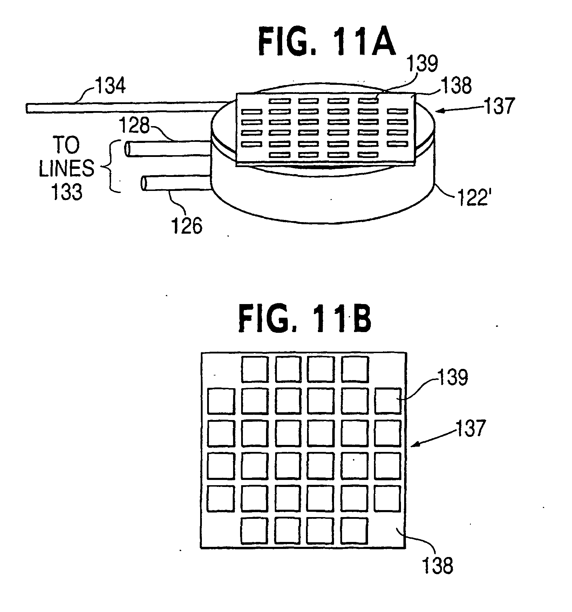

Figs. 11 A and 11 B are respective perspective and top views of alternative and embodiment used to control singulated devices. "Singulating" refers to separating the devices, and singulated, devices are not necessarily in any particular arrangement although they may advantageously in correspondence with their respective locations on a pre-cut wafer. In this case, the chuck 122 and heating elements are essentially the same as in the embodiment for aligning a whole wafer, as shown in Figs. 10A-10B. However, as shown in Figs. 11A and 11 B, a wafer size adapter 137 is placed over the chuck 122 and the heating element array. The wafer size adapter 137 comprises a carrier 138, having pockets 139 formed therein. The pockets correspond in shape, size, and position to the location of the IC devices in the wafer used for fabrication. Preferably, the carrier is formed of a low thermal resistance material.

The adapter 137 allows a wafer probe-type test to be performed on devices after the wafer has been cut to deliver the separate or "singulated" devices while still using the same chuck layout as would be used for a whole wafer. Thus, the positional relationship of the devices prior to separation from the wafer is retained and diagnosis of the production process is possible even though the wafer is no longer in one piece. Of course, it is not necessary to have a device in each pocket, especially if certain devices are already known to be faulty and not worth further processing or testing. Further, it is also not necessary to arrange the singulated devices on the adapter 137 in the same position that they had on the wafer. Nevertheless, arranging the singulated devices in the same position they had on the wafer provides additional testing information about the wafer. The singulated devices could also be tested individually if desired.

Each of the heating elements 149 may be incorporated into a common heat exchanger body as shown in Figs. 10A and 10B, in which each of the heating elements 149 is in thermal contact with the fluid cavity 124 of the fluid cooled chuck 122. Other embodiments may utilize multiple, separated heat sinks. These multiple sinks may be in thermal contact with individual heating elements 149 or with multiple heating elements 149. It is noted that in a preferred embodiment, the chuck 120 does not contain the heating elements 149. However, the heating elements 149 may be integrated with the chuck 120.

Although a preferred embodiment includes a chuck which supports the heating elements, any device which can hold, retain, or secure a plurality of heating elements 149 may be used instead. This may be, for example, the adapter 137, a surface, an array of columns or other support structures, or any other suitable support device. If the heating elements 149 are secured or a retaining device is used to hold them, it is also possible to contact the DUTs 182 from the side or the top. In some embodiments, only the heating elements 149 are fixedly arranged so that DUTs 182 can be aligned with them. The heating elements 149 can be fixed in their arrangement through bonding, adhesion, retention, limited space for movement, or any other suitable mechanism or device. In such embodiments, a chuck per se is unnecessary if the temperature control can be performed by the heating elements 149.

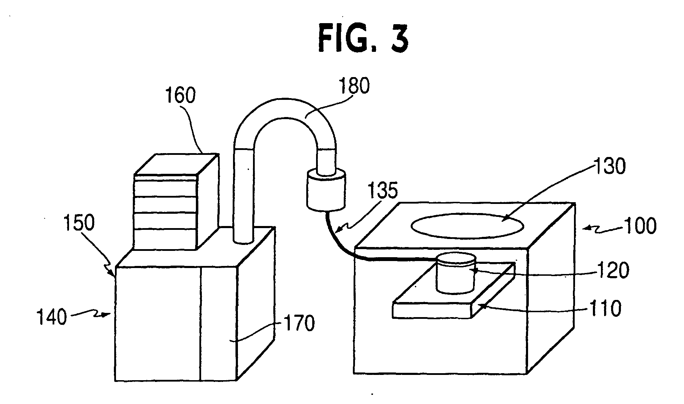

Fig. 3 illustrates an exemplary application of the invention in conjunction with a test device comprising a wafer prober 100. The wafer prober 100 may be one of several that are available, such as a UF200 prober obtainable from Tokyo Seimitsu Co., Ltd. (TSK). The wafer prober 100 includes a stage 110 carrying a chuck 120. The chuck 120 is arranged to carry a wafer (not shown) on which a number of semiconductor integrated circuit devices have been formed. Such wafers are typically 200 mm in diameter although other sizes are often used, and can have more than 200 devices formed on them. The number and arrangement of devices on the wafer will vary according to the particular design of the IC device in question.

The test device of Fig. 3 also comprises a test head interface 130 providing electrical connections, which may be applied to power and input/output pads on the devices on the wafer. The connections can be needles or any other form of contact appropriate to the device in question. The test head interface 130 is provided with connections for the test head of any of several available test systems, such as the ITS 9000 IX (not shown) of Schlumberger Technologies, Inc. of San Jose, California.

The test device of Fig. 3 further comprises a temperature control system 140. The chuck 120 is connected by way of fluid supply lines and control cables contained in a housing 135 to the temperature control system 140. The temperature control system 140 may be implemented by any of several available systems, such as an ETC 1000 manufactured by Schlumberger Technologies, Inc. The temperature control system 140 comprises a thermal control chassis 150 carrying a system controller 160 provided with an operator interface, a liquid cooling and recirculation system 170, and a boom arm 180 supporting the fluid supply lines and control cables.

Operation of the system shown in Fig. 3 is essentially the same as that described in Malinoski, *et al*., U.S. Patent Application Serial No. 09/352,762, titled "APPARATUS, METHOD AND SYSTEM OF LIQUID-BASED, WIDE RANGE, FAST RESPONSE TEMPERATURE CONTROL OF ELECTRONIC DEVICES", filed on July 14, 1999, and referred to above. Specifically, the system controls the temperature of a test device at or near a set point temperature despite potential fluctuations in the device temperature caused by self-heating.

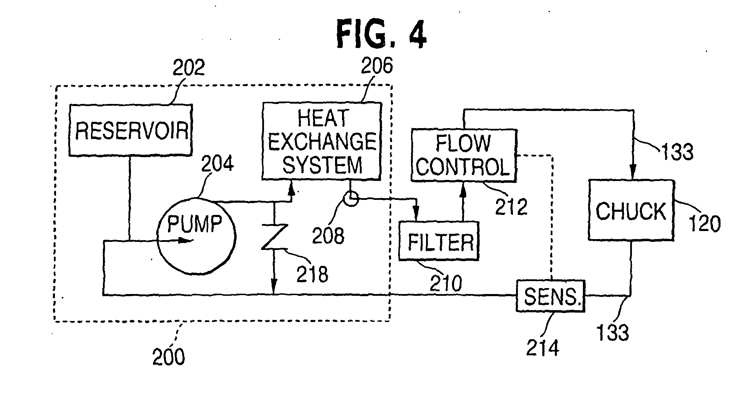

Fig. 4 shows a block diagram of the liquid cooling and recirculating system 170. As shown in Fig. 4, the liquid cooling and recirculating system 170 includes a chiller system 200, a filter 210, and a flow control 212. The chiller system comprises a pressurized coolant reservoir 202, a pump 204, a heat exchange (heating/cooling) system 206, a temperature sensor 208, and a pressure relief valve 218. Fluid passes from the chiller system 200, via the temperature sensor 208, through the filter 210 to the flow control 212 and on to the chuck 120. Fluid then returns from the chuck 120 and through a flow sensor 214 to be pumped around the liquid cooling and recirculating system 170 again. In an alternative embodiment, the flow sensor 214 can be placed in the path of the fluid flowing into the chuck 120, such as between the flow control 212 and the chuck 120. The flow sensor may also be implemented as part of the liquid cooling and recirculating system 170 in an alternative embodiment. The pressure relief valve 218 is disposed between the pump output and pump input to avoid accidentally overpressurizing the system. The fluid flows into and out of the heat exchanger 216 through the fluid supply lines 133.

In one embodiment of the present invention, the heat exchanger 216 exchanges heat between the liquid cooling and recirculating system 170 and a DUT. In other embodiments, however, the heat exchanger 216 may include the liquid or the liquid cooling and recirculating system 170.

The cooling fluid may be, for example, HFE7100 operating between - 40°C and +40°C, water/glycol or water/methanol mixtures operating between + 10°C and + 90°C, or any other suitable fluid depending on the desired temperature and heat dissipation required. HFE7100 is a specialty liquid manufactured by 3M corporation, which contains ethyl nonafluorobutylether and ethyl nonafluoroisobutylether. In operation, the difference between the device set point temperature and the fluid temperature can be in the range of 5°C to 160°C, with device set point temperatures typically in the range of -35°C to + 170°C.

As shown in Fig. 4, liquid circulating through the chuck 120 is cooled below a set point temperature. The heating element 149 of Fig. 2B, which is in thermal contact with the chuck 120 and a DUT 182, is used to maintain the temperature of the DUT 182 at the set point temperature. In such an embodiment, the chuck 120 acts as a heat sink by absorbing heat energy from the heating element 149 and, at times, indirectly, from the test device 182.

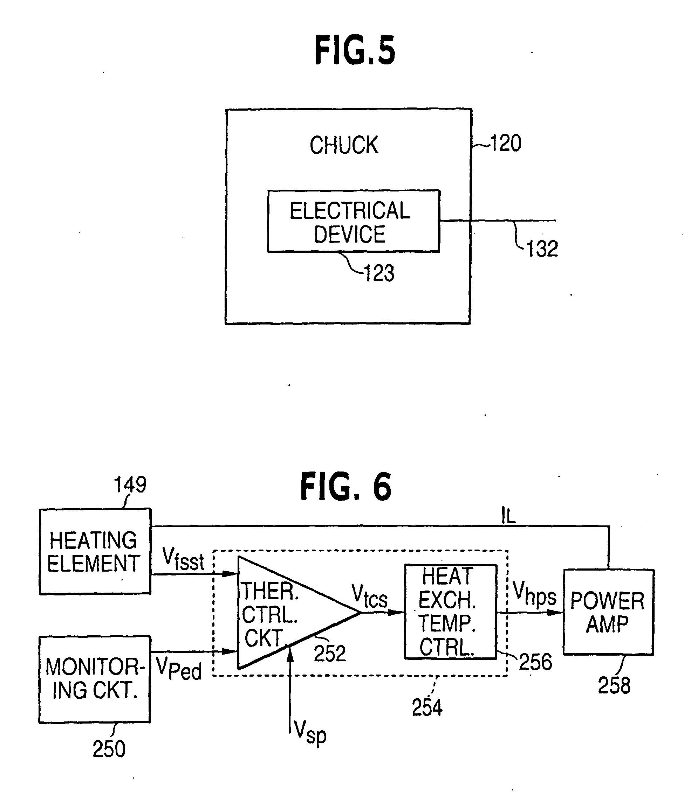

It will be appreciated that other systems besides the liquid cooling and recirculating system may be used to vary the temperature of the chuck. For example, forced air systems, electric heaters, Peltier devices, highly conductive construction materials for the chuck 120, and ambient air with a large temperature differential would each allow the chuck 120 to act as a device for exchanging heat. One of these examples is shown in Fig. 5, where an electrical device 123 is contained within the chuck 120 and is controlled by control lines 132.

Fig. 6 shows a high level block diagram of the control electronics of the system controller 160 of the temperature control system 140 shown in Fig. 3. Variables in the control electronics system include (i) a signal $V_{fsst}$, representing a system forcing temperature $T_{fss}$ of the heating element 149, measured by a temperature sensor in a heating element (not shown), (ii) a signal $V_{Ped}$ representing a device power consumption, $P_{ed}$, measured by a monitoring circuit 250, which calculates the heat generated by the device (not shown) from the power drawn by the device during the test, and (iii) a signal $V_{sp}$ representing a device set-point temperature $T_{sp}$, which is set by the user. These variables are provided as inputs to a thermal control circuit 252 forming part of a thermal control board 254 in the system controller 160.

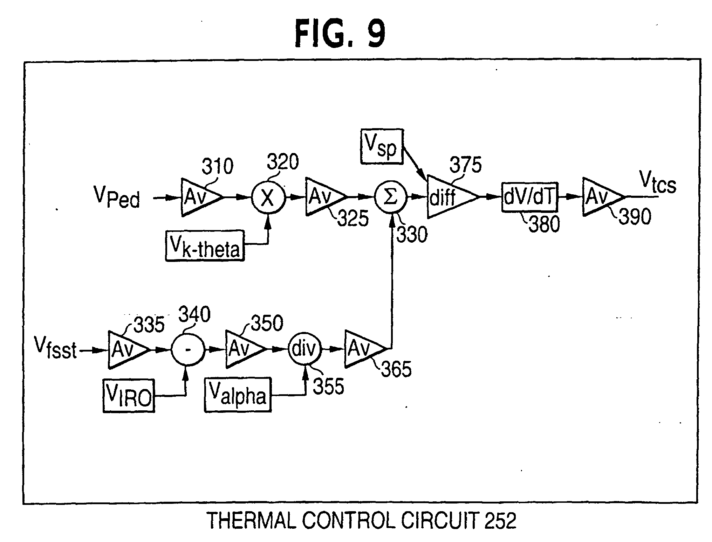

The thermal control circuit 252 generates a temperature control signal $V_{tcs}$ in a manner described below with respect to Fig. 9 and provides this signal to a heat exchanger temperature control 256 on the board 254. The heat exchanger temperature control 256 outputs a heater power signal $V_{hps}$ to a power amplifier 258, which provides a heater power $I_h$ to the heating element 149.

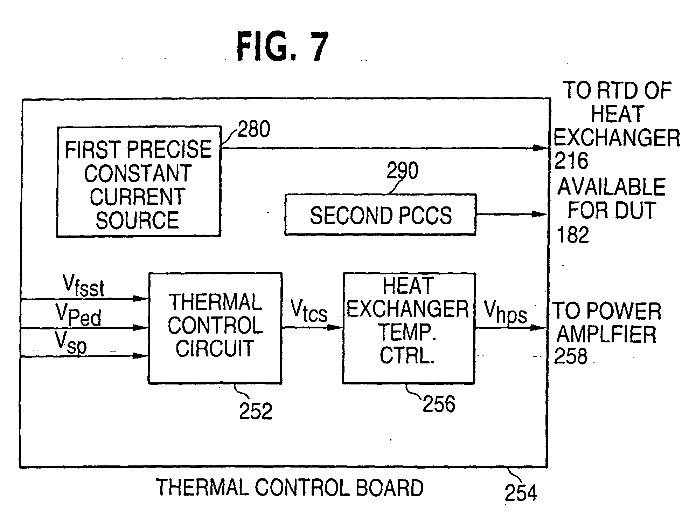

Fig. 7 shows a more detailed block diagram of the thermal control board 254. As shown in Fig. 7, the thermal control board 254 comprises, in addition to the thermal control circuit 252 and the heat exchanger temperature control 256, a first precise constant current source 280 and a second precise constant current source 290. The first precise constant current source 280 sends a precise constant current from the thermal control board 254 to a variable resistance device ("RTD") in the heating element 149. The RTD responds to the system forcing temperature and outputs a voltage representing the system forcing temperature $V_{fsst}$. The system forcing temperature signal feeds back into the thermal control circuit 252. Separating the first precise constant current source 280 from the heater 149 allows in that the heater 149 to be replaced more easily. The second precise constant current source 290 is available to send a precise constant current to the DUT.

Although only one thermal control board 254 is shown in Fig. 6, multiple boards can be provided. The use of multiple boards would allow simultaneous operation of a plurality of heating elements 149, each of which could be contained in the heat exchanger 216 and be thermally coupled to individual DUTs 182, as shown in Fig. 8A. Each separate board 254 would preferably have a separate set of inputs ($V_{fsst}$, $V_{Ped}$, $V_{sp}$) and the various values of $V_{fsst}$ would come from the plurality heating elements 149. Separate monitoring circuits 250 could be used to monitor the power of the individual DUTs 182, and separate power amplifiers 258 could be used for each heating element 149. It may be possible, however, for the separate power amplifiers 258 to be housed in a single device.

Fig. 9 shows a more detailed block diagram of the thermal control circuit 252. Such thermal control circuit is described in more detail in commonly assigned U.S. Patent Application Serial No. 09/352,760 to Jones, *et al.*, titled "TEMPERATURE CONTROL OF ELECTRONIC DEVICES USING POWER FOLLOWING FEEDBACK," the disclosure of which is hereby fully incorporated as if fully set forth herein. That application discloses, among other things, a power following feedback control method. The temperature of the device under test can be determined using the following equation:

$$\text{Device Temperature} = K_{theta} * P_{ed} + T_{fss}$$

Where:

- Device Temperature (°C) represents the device temperature derived from its power dissipation.
- $K_{theta}$ is a constant (°C/watts) derived from the capabilities of the temperature control system and the thermal resistance of the medium (or media, in those cases where heat spreaders, lids, or other devices are attached to the top of the device itself) between the electronic device and the heat exchanger
- $P_{ed}$ (watts) is the total power usage of the DUT, represented by the signal $V_{Ped}$ which is obtained from the monitoring circuit 250 and which represents the power, in watts, consumed by the DUT.
- $T_{fss}$ (°C) is the system forcing temperature and is the absolute temperature of the medium contacting the device, as measured by a temperature sensor embedded in the thermal control system surface (preferably the surface of a heating element in the heat exchanger 216). $T_{fss}$ is represented by the signal $V_{fsst}$.

$K_{theta}$ is also derived from the general efficiency of the thermal control system when in contact with a DUT 182. For example, at set point temperatures well above ambient, the DUT 182 loses proportionally more heat to its surroundings, and the thermal control system must work harder to raise the DUT temperature than to lower it. From the standpoint of a thermal control system responding to DUT self-heating, the overall effect is the same as a lower thermal resistance between the DUT 182 and the heat exchanger 216 operating at an ambient set point. Similarly, at set point temperatures well below ambient, the DUT 182 gains heat from its surroundings, and the temperature control system 140 must work harder to lower temperature than to raise it. From the standpoint of the temperature control system responding to DUT self-heating, the overall effect is the same as a higher thermal resistance between the DUT 182 and the heat exchanger 216 operating at an ambient set point. In both cases, $K_{theta}$ is adjusted to reflect the effect of heat transfer to the DUT's surrounding environment during power excursions.

$K_{theta}$ may be considered an effective or a fine-tuned thermal resistance of the medium. Although the thermal resistance of different media are set out in standard chemistry reference books (such as CRC Handbook of Chemistry and Physics, 77th Edition; David R. Lide, Editor-in-Chief), factors such as ambient humidity, pressure, and temperature may affect the actual thermal resistance. Thermal resistance may also be affected by the physical configuration of the test. To determine $K_{theta}$, one can use a calibration process to adjust the value of the anticipated thermal resistance of the medium and ascertain whether the result is an improvement. Another advantage of a calibration process is that it will automatically account for the "efficiency factor" of the heat transfer from the DUT 182 to the temperature control system 140 as a function of the set point temperature.,

As described above $K_{theta}$ may incorporate the effects of a variety of variables into one term. In the preferred embodiment, $K_{theta}$ may be optimized for a given application, or type of DUT 182, and then can be used to test many different devices of the same type. Additionally, one practical effect of $K_{theta}$ is that in mirroring the monitored power consumption of the device with the temperature of the test device, $K_{theta}$ magnifies or compresses the relative magnitude of the mirroring.

The temperature control signal is determined using the following equation:

$$V_{tcs} = d(V_{sp} - ((V_{k\text{-}theta} * V_{Ped}) + (V_{fsst} - V_{IRO}/V_{alpha})))/dt$$

Where:

- $V_{tcs}$ is the temperature control signal.
- $V_{sp}$ is a voltage representing the set-point temperature, $T_{sp}$, for the device.
- $V_{k\text{-}theta}$ is a voltage representing the $K_{theta}$ value. The $K_{theta}$ value is input into a digital to analog converter which generates a voltage corresponding to the value of the input.
- $V_{fsst}$ is a voltage representing the forcing system surface temperature, $T_{fss}$, and generated by digital to analog conversion.
- $V_{IRO}$ is a voltage representing a voltage equal to the value of the precise constant current from the first precise constant current source 280 in the thermal control board 254 multiplied by the resistance shown by the variable resistance device in the heat exchanger at 0 degrees C and generated by digital to analog conversion. This voltage can be determined when the embedded temperature sensor in the heat exchanger is calibrated.
- $V_{alpha}$ is a voltage representing the slope of a curve for the variable resistance device in the heat exchanger of resistance versus temperature and generated by digital to analog conversion. This voltage can be determined when the embedded temperature sensor in the heat exchanger is calibrated.

Returning to Fig. 9, the power usage signal $V_{Ped}$ from the monitoring circuit 250 shown in Fig. 6 enters the thermal control circuit 252 by passing through a first amplifier 310. From there, the power usage signal passes into a multiplying circuit 320 where it is multiplied with $V_{k\text{-}theta}$ to create a first modified signal. The modified power usage signal then passes into a second amplifier 325 and from there into a thermal summing circuit 330. The voltage $V_{fsst}$ representing the system forcing temperature enters the thermal control circuit 252 by passing through a third amplifier 335. From there, $V_{fsst}$ passes into a subtracting circuit 340 where $V_{IRO}$ is subtracted from $V_{fsst}$ for a calibrated $V_{fsst}$. The calibrated $V_{fsst}$ passes through a fourth amplifier 350 and into a divisional circuit 355 where the calibrated $V_{fsst}$ is divided by $V_{alpha}$. A result representing $(V_{fsst} - V_{IRO})/V_{alpha}$ passes through a fifth amplifier 365 and from there passes into the thermal summing circuit 330, and is summed there with the modified power usage signal to yield a summation. The summation passes into a differential circuit (or subtraction circuit) 375 which subtracts the summation from the set point temperature voltage, $V_{sp}$, to yield a resulting signal. The resulting signal passes into a derivative circuit 380 which takes the derivative of the resulting signal with respect to time. This yields the temperature control signal $V_{tcs}$ which is amplified by a sixth amplifier 390 before being output from the thermal control circuit 252.

Other methods of controlling the heat exchanger 216 may also be used. For example, commonly assigned U.S. Patent Application Serial No. 08/734,212

describes, among other things, open loop control with power profiles. Other open loop methods, for example and without limitation, may monitor the temperature of the DUT 182 or of some other location in the test system. Still other methods may use feedback systems based on, for example and without limitation, the DUT temperature, the heat exchanger temperature, or the power drawn by the heat exchanger. Examples of temperature control devices include, without limitation, resistive heating elements and all substitutes mentioned therefore above, and liquid heat exchangers and all substitutes mentioned therefore above.

This disclosure has described a test device which, among other things, allows the benefit of a heat exchanger to be applied to a wafer prober for temperature control of devices during testing. The present system is capable of providing a variety of other functions. Some of these additional functions include test control, temperature determination, and data acquisition.

In addition, while the preferred implementation comprises a liquid cooled heat exchanger and an electric heating element, the exact method of providing cooling or heating can be chosen from any suitable source. For example, heated liquids or gases can be used as the heating element.

Also in a preferred implementation, a feedback loop is used to control the operation of the heating element while the liquid cooled heat exchanger is operated as a set point heat sink. Other methods of control, such as device power consumption monitoring or test power consumption profiling, can also be used.

The present invention also provides a method for testing IC devices at wafer level in which the temperature of each device on the wafer is controlled independently of the other devices on the wafer during a test. In addition, the test can be run at high speed without the danger of heat damage to the devices.

While the invention outlined above is discussed mainly in terms of wafer-level testing, it can also be applied to multiple singulated (that is, separated) devices. Preferably, these devices are arranged in a carrier in the same arrangement in which they were formed on the wafer. By retaining, during testing, the layout which the devices had on the wafer, production problems may be identified which depend on the position of a device on a wafer. This retention of the layout allows diagnosis of the production process and may improve yield.

The principles, preferred embodiments, and modes of operation of the present invention have been described in the foregoing specification. The invention is not to be construed as limited to the particular forms disclosed, because these are regarded as illustrative rather than restrictive. Moreover, variations and changes may be made by those of ordinary skill in the art without departing from the scope of the claims.

## Claims

1.   An apparatus for temperature control of integrated circuit devices (20) under test, comprising:

a heat exchanger (216) having a surface disposed to contact each of the plurality of integrated circuit devices, said surface having a plurality of regions corresponding to respective ones of the plurality of integrated circuit devices, the heat exchanger adapted to provide controlled heating and cooling at said regions

wherein the temperature of each of the plurality of integrated circuit devices is individually controlled at each of the plurality of regions during testing.

2.   An apparatus according to claim 1, wherein the heat exchanger comprises a chuck (120) having a plurality of heating elements (149) disposed at each of said regions.

3.   An apparatus according to claim 2, wherein the chuck includes a heat sink (10), each of said heating elements regulating the temperature of a corresponding one of said regions at a temperature above a temperature determined by the heat sink.

4.   An apparatus according to claim 3, wherein the heat sink defines a cavity (124) adapted to be provided with a flow of temperature-controlled fluid.

5.   An apparatus according to claim 4, wherein the temperature of the fluid and the heating elements are regulated based on the power usage of said plurality of integrated circuit devices.

6.   An apparatus according to claim 1, wherein one of a plurality of heater elements (149) is provided at each of the plurality of the regions.

7. An apparatus according to claim 1. wherein the temperature of each region is individually controlled by a heating element (149) disposed on a heat sink (10).

8. An apparatus according to claim 7, wherein each of said heating elements is disposed over a corresponding one of a plurality of heat sinks.

9. An apparatus according to claim 7, wherein each of said heating elements is disposed over a single heat sink.

10. An apparatus according to any preceding claim, wherein the temperature of each of the plurality of integrated circuit devices is individually controlled based on the power usage of said integrated circuit devices.

11. An apparatus according to any one of claims 1 to 10, wherein the plurality of integrated circuit device are formed on a wafer and the surface is disposed to contact the wafer such that the plurality of regions correspond to respective ones of the plurality of integrated circuit devices formed on the wafer.

12. An apparatus according to any one of claims 1 to 10, wherein the plurality of integrated circuit devices are singulated devices, and the surface is disposed to contact the singulated devices such that the plurality of regions correspond to respective ones of the singulated devices.

13. Apparatus according to claim 1, wherein the heat exchanger comprises:

    a chuck (120) for locating the devices during testing; and
    multiple temperature control devices (149) to individually control the temperature of each of the plurality of integrated circuit devices are arranged in the chuck to correspond with the arrangement on a wafer of the devices being tested.

14. Apparatus as claimed in claim 13, wherein the chuck is provided with means for controlling its temperature during the testing.

15. Apparatus as claimed in claim 14, wherein the means for controlling the chuck temperature includes a supply of temperature-controlled fluid (170).

16. Apparatus as claimed in claim 14, wherein the means for controlling the chuck temperature comprises an electrical heating device (123).

17. Apparatus as claimed in any one of claims 13 to 16, wherein the multiple temperature control devices comprise heating elements (149).

18. Apparatus as claimed in claim 17, further comprising at least one heat sink (10) associated with the heating elements.

19. Apparatus as claimed in claim 18, wherein the at least one heat sink comprises a body provided with a flow of temperature-controlled fluid (170).

20. Apparatus as claimed in claim 18, wherein a heat sink is provided for each heating element.

21. Apparatus as claimed in claim 18, wherein a single heat sink is provided for the multiple heating elements.

22. Apparatus as claimed in claim 21, wherein the single heat sink is incorporated into the chuck.

23. Apparatus as claimed in claim 22, wherein the temperature of the chuck is regulated by a temperature-controlled fluid (170).

24. A method of controlling the temperature of a plurality of integrated circuit devices (20) during testing, comprising:

    placing the plurality of integrated circuit devices in contact with a respective one of a plurality of regions of a surface of a heat exchanger (216) adapted to provide controlled heating and cooling at said regions; and
    controlling individually the temperature of each of the plurality of integrated circuit devices at each of the plurality of regions.

25. A method according to claim 24, wherein the heat exchanger comprises a chuck (120) having a plurality of heating elements (149) disposed at each of said regions.

26. A method according to claim 25, wherein the chuck includes a heat sink (10), and
wherein the controlling includes regulating the temperature of a corresponding one of said regions with said heating elements at a temperature above a temperature determined by the heat sink.

27. A method according to claim 26, wherein the heat sink defines a cavity adapted to be provided with a flow of temperature-controlled fluid (170).

28. A method according to claim 24, further comprising:

providing one of a plurality of heater elements (149) at each of the plurality of regions.

29. A method according to claim 24, wherein the temperature of each region is individual controlled by a heating element (149) disposed on a heat sink (10).

30. A method according to claim 29, further comprising:

disposing said heating elements over a corresponding one of a plurality of heat sinks.

31. A method according to claim 29, further comprising:

disposing said heating elements over a single heat sink.

32. A method according to any one of claims 24 to 31, wherein the plurality of integrated circuit device are formed on a wafer and the surface is disposed to contact the wafer such that the plurality of regions correspond to respective ones of the plurality of integrated circuit devices formed on the wafer.

33. A method according to any one of claims 24 to 31, wherein the plurality of integrated circuit devices are singulated devices, and the surface is disposed to contact the singulated devices such that the plurality of regions correspond to respective ones of the singulated devices.

34. A method according to any one of claims 24 to 33, wherein the temperature of each of the plurality of integrated circuit devices is individually controlled based on the power usage of said integrated circuit devices.

35. A method according to claim 24, wherein the placing the plurality of integrated circuit devices comprises:

locating the integrated circuit devices at a test location at which multiple temperature control devices (149) are arranged to correspond with the arrangement of the integrated circuit devices being tested;
and the method further comprises:

testing individual ones of the integrated circuit devices.

36. A method as claimed in claim 35, wherein the integrated circuit devices are located on a wafer.

37. A method as claimed in claim 35, wherein the integrated circuit devices are singulated before testing.

38. A method as claimed in claim 37, wherein the singulated devices are arranged on the chuck in the same arrangement as when they were formed on a wafer.

39. A method as claimed in any one of claims 35 to 38, wherein locating the integrated circuit devices includes placing the devices on a chuck (120).

40. A method according to claim 39, wherein the chuck has multiple surfaces corresponding to each device being tested, the temperature of which is controlled to control the temperature of individual devices being tested.

**Patentansprüche**

1. Vorrichtung für die Temperatursteuerung von integrierten Schaltkreiseinrichtungen (20) in der Prüfung, die aufweist:

   einen Wärmetauscher (216) mit einer Oberfläche, die derart eingerichtet ist, daß sie mit jeder der Mehrzahl von integrierten Schaltkreiseinrichtungen in Kontakt tritt, wobei die Oberfläche eine Mehrzahl von Regionen hat, die jeweils einer der Mehrzahl von integrierten Schaltkreiseinrichtungen entsprechen, wobei der Wärmetauscher angepaßt ist, damit er eine gesteuerte Aufheizung und Abkühlung an diesen Regionen bereitstellt,

   wobei die Temperatur von jedem der Mehrzahl von integrierten Schaltkreiseinrichtungen individuell an jeder der Mehrzahl von Regionen während der Prüfung gesteuert wird.

2. Vorrichtung nach Anspruch 1, wobei der Wärmetauscher ein Chuck bzw. Futter (120) aufweist mit einer Mehrzahl von Heizelementen (149), die an jeder der Regionen angeordnet sind.

3. Vorrichtung nach Anspruch 2, wobei das Futter eine Wärmesenke (10) beinhaltet, wobei jedes der Heizelemente die Temperatur eines der Bereiche bzw. einer der Regionen auf eine Temperatur oberhalb einer Temperatur, die von der Wärmesenke bestimmt wird, reguliert.

4. Vorrichtung nach Anspruch 3, wobei die Wärmesenke eine Kavität (124) definiert, die derart angepaßt ist, daß sie mit einem temperaturgesteuerten Fluidstrom ausgestattet ist.

5. Vorrichtung nach Anspruch 4, wobei die Temperatur des Fluids und der Heizelemente basierend auf dem Leistungsverbrauch der Mehrzahl von integrierten Schaltkreiseinrichtungen reguliert wird.

6. Vorrichtung nach Anspruch 1, wobei eines der Mehrzahl von Heizelementen (149) an jeder der Mehrzahl von Regionen bereitgestellt wird.

7. Vorrichtung nach Anspruch 1, wobei die Temperatur jeder Region individuell von einem Heizelement (149), das an einer Wärmesenke (10) angeordnet ist, gesteuert wird.

8. Vorrichtung nach Anspruch 7, wobei jedes der Heizelemente über einer entsprechenden Wärmesenke von einer Mehrzahl von Wärmesenken angeordnet ist.

9. Vorrichtung nach Anspruch 7, wobei jedes Heizelement über einer einzelnen Wärmesenke angeordnet ist.

10. Vorrichtung nach einem der vorherigen Ansprüche, wobei die Temperatur von jeder der Mehrzahl von integrierten Schaltkreiseinrichtungen individuell gesteuert wird basierend auf dem Energieverbrauch der integrierten Schaltkreiseinrichtungen.

11. Vorrichtung nach einem der Ansprüche 1 bis 10, wobei die Mehrzahl von integrierten Schaltkreiseinrichtungen auf einem Wafer ausgebildet ist und die Oberfläche so eingerichtet ist, daß sie den Wafer berührt, so daß die Mehrzahl von Regionen den jeweiligen Einrichtungen der Mehrzahl von integrierten Schaltkreiseinrichtungen, die auf dem Wafer gebildet sind, entspricht.

12. Vorrichtung nach einem der Ansprüche 1 bis 10, wobei die Mehrzahl von integrierten Schaltkreiseinrichtungen singularisierte Einrichtungen sind und die Oberfläche derart eingerichtet ist, daß sie die singularisierten Einrichtungen kontaktiert, so daß die Mehrzahl von Regionen zu entsprechenden Einrichtungen der singularisierten Einrichtungen korrespondieren.

13. Vorrichtung nach Anspruch 1, wobei der Wärmetauscher aufweist:

    ein Futter (120) für das Lokalisieren der Einrichtungen während der Prüfung und
    mehrere Temperatursteuervorrichtungen (149), um individuell die Temperatur von jeder der Mehrzahl von integrierten Schaltkreiseinrichtungen zu steuern, die in dem Futter angeordnet sind, um mit der Anordnung auf einem Wafer der zu testenden Einrichtungen zu korrespondieren.

**14.** Vorrichtung nach Anspruch 13, wobei das Futter mit Einrichtungen für die Steuerung seiner Temperatur während des Prüfens ausgestattet ist.

**15.** Vorrichtung nach Anspruch 14, wobei die Einrichtung für das Steuern der Futtertemperatur die Zuführung eines temperaturgesteuerten Fluids (170) beinhaltet.

**16.** Vorrichtung nach Anspruch 14, wobei die Einrichtung für das Steuern der Futtertemperatur eine elektrische Heizeinrichtung (123) aufweist.

**17.** Vorrichtung nach einem der Ansprüche 13 bis 16, wobei die mehreren Temperatursteuereinrichtungen Heizelemente (149) aufweisen.

**18.** Vorrichtung nach Anspruch 17, die weiterhin zumindest eine Wärmesenke (10), die mit den Heizelementen verknüpft ist, aufweist.

**19.** Vorrichtung nach Anspruch 18, wobei die zumindest eine Wärmesenke einen Körper aufweist, der mit einem Fluß von temperaturgesteuertem Fluid (170) ausgestattet ist.

**20.** Vorrichtung nach Anspruch 18, wobei eine Wärmesenke für jedes Heizelement bereitgestellt wird.

**21.** Vorrichtung nach Anspruch 18, wobei eine einzelne Wärmesenke für die mehreren Heizelemente bereitgestellt wird.

**22.** Vorrichtung nach Anspruch 21, wobei die einzelne Wärmesenke in dem Futter aufgenommen ist.

**23.** Vorrichtung nach Anspruch 22, wobei die Temperatur des Futters von einem temperaturgesteuerten Fluid (170) reguliert wird.

**24.** Verfahren zum Steuern der Temperatur einer Mehrzahl von integrierten Schaltkreiseinrichtungen (20) während der Überprüfung, das aufweist:

Plazieren der Mehrzahl von integrierten Schaltkreiseinrichtungen in Kontakt mit einer einer Mehrzahl von Regionen einer Oberfläche eines Wärmetauschers (216), die eingerichtet sind, um bei den Regionen ein gesteuertes Heizen und Kühlen bereitzustellen, und

individuelles Steuern der Temperatur von jeder der Mehrzahl von integrierten Schaltkreiseinrichtungen an jeder der Mehrzahl von Regionen.

**25.** Verfahren nach Anspruch 24, wobei der Wärmetauscher ein Futter (120) mit einer Mehrzahl von Heizelementen (149), die an jeder der Regionen angeordnet sind, aufweist.

**26.** Verfahren nach Anspruch 25, wobei das Futter eine Wärmesenke (10) aufweist und
wobei das Steuern das Regulieren der Temperatur einer entsprechenden der Regionen mit den Heizelementen bei einer Temperatur oberhalb einer Temperatur, die durch die Wärmesenke bestimmt wird, beinhaltet.

**27.** Verfahren nach Anspruch 26, wobei die Wärmesenke eine Kavität festlegt, die derart angepaßt ist, daß sie mit einem Fluß eines temperaturgesteuerten Fluids (170) ausgestattet ist.

**28.** Verfahren nach Anspruch 24, das weiterhin aufweist:

Bereitstellen von einem einer Mehrzahl von Heizelementen (149) an jeder der Mehrzahl von Regionen.

**29.** Verfahren nach Anspruch 24, wobei die Temperatur von jeder Region einzeln von einem Heizelement (149), das auf einer Wärmesenke (10) angeordnet ist, gesteuert wird.

**30.** Verfahren nach Anspruch 29, das weiterhin aufweist:

Anordnen der Heizelemente mit einer entsprechenden der Mehrzahl von Wärmesenken.

**31.** Verfahren nach Anspruch 29, das weiterhin aufweist:

Anordnen der Heizelemente über einer einzelnen Wärmesenke.

**32.** Verfahren nach einem der Ansprüche 24 bis 31, wobei die Mehrzahl von integrierten Schaltkreiseinrichtungen auf einem Wafer gebildet werden und die Oberfläche derart eingerichtet wird, daß sie den Wafer kontaktiert, so daß die Mehrzahl von Regionen entsprechenden Einrichtungen der Mehrzahl von integrierten Schaltkreiseinrichtungen, die auf dem Wafer ausgebildet sind, entspricht.

**33.** Verfahren nach einem der Ansprüche 24 bis 31, wobei die Mehrzahl von integrierten Schaltkreiseinrichtungen singularisierte Einrichtungen sind und die Oberfläche derart angeordnet ist, daß sie die singularisierten Einrichtungen kontaktiert, so daß die Mehrzahl von Regionen entsprechenden Einrichtungen der singularisierten Einrichtungen entsprechen.

**34.** Verfahren nach einem der Ansprüche 24 bis 33, wobei die Temperatur von jeder der Mehrzahl von integrierten Schaltkreiseinrichtungen individuell basierend auf dem Leistungsverbrauch der integrierten Schaltkreiseinrichtungen gesteuert wird.

**35.** Verfahren nach Anspruch 24, wobei das Plazieren der Mehrzahl von integrierten Schaltkreiseinrichtungen aufweist:

Lokalisieren der integrierten Schaltkreiseinrichtungen an einem Testort, an dem mehrere Temperatursteuereinrichtungen (149) angeordnet sind, so daß sie mit der Anordnung der integrierten Schaltkreiseinrichtungen, die getestet werden, korrespondieren,

und wobei das Verfahren weiterhin aufweist:

Testen einzelner der integrierten Schaltkreiseinrichtungen.

**36.** Verfahren nach Anspruch 25, wobei die integrierten Schaltkreiseinrichtungen auf einem Wafer lokalisiert sind.

**37.** Verfahren nach Anspruch 35, wobei die integrierten Schaltkreiseinrichtungen vor der Überprüfung singularisiert werden.

**38.** Verfahren nach Anspruch 37, wobei die singularisierten Einrichtungen auf einem Futter in derselben Anordnung angeordnet sind, als ob sie auf einem Wafer ausgebildet wären.

**39.** Verfahren nach einem der Ansprüche 35 bis 38, wobei das Lokalisieren der integrierten Schaltkreiseinrichtungen das Plazieren der Einrichtungen auf einem Futter (120) beinhaltet.

**40.** Verfahren nach Anspruch 39, wobei das Futter mehrere Oberflächen hat, die zu jeder zu überprüfenden Einrichtung korrespondieren, wobei die Temperatur hiervon gesteuert wird, um die Temperatur der einzelnen Einrichtungen, die überprüft werden, zu steuern.

**Revendications**

**1.** Appareil de commande de la température de dispositifs à circuit intégré (20) à l'essai, comprenant :

un échangeur thermique (216) ayant une surface disposée afin d'entrer en contact avec chacun de la pluralité de dispositifs à circuit intégré, ladite surface possédant une pluralité de régions correspondant aux dispositifs respectifs parmi la pluralité de dispositifs à circuit intégré, l'échangeur thermique étant conçu pour fournir un chauffage et un refroidissement contrôlés au niveau desdites régions,

dans lequel la température de chacun de la pluralité de dispositifs à circuit intégré est commandée individuellement au niveau de chacune de la pluralité de régions pendant l'essai.

**2.** Appareil selon la revendication 1, dans lequel l'échangeur thermique comprend un plateau de fixation (120) ayant une pluralité d'éléments chauffants (149) disposés au niveau de chacune desdites régions.

3. Appareil selon la revendication 2, dans lequel le plateau de fixation comprend un dissipateur thermique (10), chacun desdits éléments chauffants régulant la température de l'une, correspondante, desdites régions à une température supérieure à la température déterminée par le dissipateur thermique.

4. Appareil selon la revendication 3, dans lequel le dissipateur thermique définit une cavité (124) conçue pour recevoir un flux de fluide à température contrôlée.

5. Appareil selon la revendication 4, dans lequel la température du fluide et les éléments chauffants sont régulés sur la base de la consommation électrique de ladite pluralité de dispositifs à circuit intégré.

6. Appareil selon la revendication 1, dans lequel un de la pluralité d'éléments chauffants (149) est prévu au niveau de chacune de la pluralité de régions.

7. Appareil selon la revendication 1, dans lequel la température de chaque région est commandée individuellement par un élément chauffant (149) disposé sur un dissipateur thermique (10).

8. Appareil selon la revendication 7, dans lequel chacun desdits éléments chauffants est disposé au-dessus d'un de la pluralité de dissipateurs thermiques qui lui correspond.

9. Appareil selon la revendication 7, dans lequel chacun desdits éléments chauffants est disposé au-dessus d'un dissipateur thermique unique.

10. Appareil selon l'une quelconque des revendications précédentes, dans lequel la température de chacun des dispositifs à circuit intégré est commandée individuellement sur la base de la consommation électrique desdits dispositifs à circuit intégré.

11. Appareil selon l'une quelconque des revendications 1 à 10, dans lequel la pluralité de dispositifs à circuit intégré est formée sur une plaquette et la surface est disposée pour entrer en contact avec la plaquette de telle manière que la pluralité de régions corresponde aux dispositifs respectifs parmi la pluralité de dispositifs à circuit intégré formés sur la plaquette.

12. Appareil selon l'une quelconque des revendications 1 à 10, dans lequel la pluralité de dispositifs à circuit intégré sont des dispositifs individualisés et la surface est disposée pour entrer en contact avec les dispositifs individualisés de telle manière que la pluralité de régions corresponde aux dispositifs respectifs des dispositifs individualisés.

13. Appareil selon la revendication 1, dans lequel l'échangeur thermique comprend :

    un plateau de fixation (120) pour y placer les dispositifs pendant l'essai ; et
    de multiples dispositifs de commande de la température (149) afin de commander individuellement la température de chacun de la pluralité de dispositifs à circuit intégré, sont agencés dans le plateau de fixation afin de correspondre à l'agencement des dispositifs à l'essai sur une plaquette.

14. Appareil selon la revendication 13, dans lequel le plateau de fixation est doté d'un moyen pour commander sa température pendant l'essai.

15. Appareil selon la revendication 14, dans lequel le moyen pour commander la température du plateau de fixation comprend une alimentation de fluide à température contrôlée (170).

16. Appareil selon la revendication 14, dans lequel le moyen pour commander la température du plateau de fixation comprend un dispositif de chauffage électrique (123).

17. Appareil selon l'une quelconque des revendications 13 à 16, dans lequel les multiples dispositifs de commande de température comprennent des éléments chauffants (149).

18. Appareil selon la revendication 17, comprenant en outre au moins un dissipateur thermique (10) associé aux éléments chauffants.

19. Appareil selon la revendication 18, dans lequel le, au moins un, dissipateur thermique, comprend un corps doté d'un flux de fluide à température contrôlée (170).

20. Appareil selon la revendication 18, dans lequel un dissipateur thermique est prévu pour chaque élément chauffant.

21. Appareil selon la revendication 18, dans lequel un unique dissipateur thermique est prévu pour les multiples éléments chauffants.

22. Appareil selon la revendication 21, dans lequel l'unique dissipateur thermique est intégré dans le plateau de fixation.

23. Appareil selon la revendication 22, dans lequel la température du plateau de fixation est régulée par un fluide à température contrôlée (170).

24. Procédé de commande de la température d'une pluralité de dispositifs à circuit intégré (20) pendant l'essai, comprenant les étapes consistant à :

   placer la pluralité de dispositifs à circuit intégré en contact avec l'une, respective, de la pluralité de régions d'une surface d'un échangeur thermique (216) adapté pour fournir un chauffage et un refroidissement contrôlés au niveau desdites régions ; et
   commander individuellement la température de chacun de la pluralité de dispositifs à circuit intégré au niveau de chacune de la pluralité de régions.

25. Procédé selon la revendication 24, dans lequel l'échangeur thermique comprend un plateau de fixation (120) ayant une pluralité d'éléments chauffants (149) disposés au niveau de chacune desdites régions.

26. Procédé selon la revendication 25, dans lequel le plateau de fixation inclut un dissipateur thermique (10), et
   dans lequel la commande inclut la régulation de la température d'une, correspondante, desdites régions à l'aide desdits éléments chauffants à une température supérieure à une température définie par le dissipateur thermique.

27. Procédé selon la revendication 26, dans lequel le dissipateur thermique définit une cavité conçue pour recevoir un flux de fluide à température contrôlée (170).

28. Procédé selon la revendication 24, comprenant en outre l'étape consistant à :

   fournir un d'une pluralité d'éléments chauffants (149) au niveau de chacune de la pluralité de régions.

29. Procédé selon la revendication 24, dans lequel la température de chaque région est commandée individuellement par un élément chauffant (149) disposé sur un dissipateur thermique (10).

30. Procédé selon la revendication 29, comprenant en outre l'étape consistant à :

   disposer lesdits éléments chauffants au-dessus de l'un, correspondant, d'une pluralité de dissipateurs thermiques.

31. Procédé selon la revendication 29, comprenant en outre l'étape consistant à :

   disposer lesdits éléments chauffants au-dessus d'un unique dissipateur thermique.

32. Procédé selon l'une quelconque des revendications 24 à 31, dans lequel la pluralité de dispositifs à circuit intégré sont formés sur une plaquette et la surface est disposée pour entrer en contact avec la plaquette de telle manière que la pluralité de régions corresponde aux dispositifs respectifs parmi la pluralité de dispositifs à circuit intégré formés sur la plaquette.

33. Procédé selon l'une quelconque des revendications 24 à 31, dans lequel la pluralité de dispositifs à circuit intégré sont des dispositifs individualisés et la surface est disposée pour entrer en contact avec les dispositifs individualisés de telle manière que la pluralité de régions corresponde aux dispositifs respectifs des dispositifs individualisés.

**34.** Procédé selon l'une quelconque des revendications 24 à 33, dans lequel la température de chacun de la pluralité de dispositifs à circuit intégré est commandée individuellement sur la base de la consommation électrique desdits dispositifs à circuit intégré.

**35.** Procédé selon la revendication 24, dans lequel l'étape consistant à placer la pluralité de dispositifs à circuit intégré comprend les étapes consistant à :

disposer les dispositifs à circuit intégré à un lieu d'essai où de multiples dispositifs de commande de température (149) sont agencés pour correspondre à l'agencement des dispositifs à circuit intégré à l'essai ;
et le procédé comprend en outre l'étape consistant à :

tester des dispositifs particuliers des dispositifs à circuit intégré.

**36.** Procédé selon la revendication 35, dans lequel les dispositifs à circuit intégré sont situés sur une plaquette.

**37.** Procédé selon la revendication 35, dans lequel les dispositifs à circuit intégré sont individualisés avant l'essai.

**38.** Procédé selon la revendication 37, dans lequel les dispositifs individualisés sont agencés sur le plateau de fixation selon le même agencement que lorsqu'ils étaient formés sur une plaquette.

**39.** Procédé selon l'une quelconque des revendications 35 à 38, dans lequel l'étape consistant à disposer les dispositifs à circuit intégré inclut le placement des dispositifs sur un plateau de fixation (120).

**40.** Procédé selon la revendication 39, dans lequel le plateau de fixation possède de multiples surfaces correspondant à chacun des dispositifs à l'essai, dont la température est commandée afin de commander la température des dispositifs particuliers à l'essai.

# FIG. 1

# FIG. 2A

TEMP.
CONTROL
SYSTEM

DUT ⌐182

HEAT
EXCHANGER ⌐216

140

# FIG. 2B

TEMP.
CONTROL
SYSTEM

DUT ⌐182

HEATING
ELEMENT ⌐149

CHUCK ⌐120

216

140

# FIG. 2C

DUT ⌐20

HEATING
ELEMENT ⌐14

HEAT SINK
WITH
LIQUID 12 ⌐10

216

# FIG. 3

# FIG. 4

# FIG.5

```
┌──────────────────────────────┐
│          CHUCK        ~120    │
│                               │
│    ┌──────────────────┐       │
│    │    ELECTRICAL    │───────────
│    │     DEVICE       │    ⌐132│
│    └──────────────────┘       │
│            ⌐123               │
└──────────────────────────────┘
```

# FIG. 6

# FIG. 7

THERMAL CONTROL BOARD

# FIG. 8A

182

149

CHUCK ~120

216

# FIG. 8B

182

149

DUT

HEATING ELEMENT

HEAT EXCHANGER BODY ~120

216

153

# FIG. 9

THERMAL CONTROL CIRCUIT 252

# FIG. 10A

# FIG. 10B

# FIG. 11A

# FIG. 11B